Europäisches Patentamt

European Patent Office

Office européen des brevets

(19)

(11) Veröffentlichungsnummer: **0 262 323**
A2

(12) # EUROPÄISCHE PATENTANMELDUNG

(21) Anmeldenummer: 87110738.9

(22) Anmeldetag: 24.07.87

(51) Int. Cl.³: **H 01 J 37/32**
**H 01 J 37/34**

(30) Priorität: 26.07.86 DE 3625356

(43) Veröffentlichungstag der Anmeldung:
06.04.88 Patentblatt 88/14

(84) Benannte Vertragsstaaten:
AT BE CH FR GB IT LI LU NL SE

(71) Anmelder: Biedermann, Andreas
Magenbuch 128
D-7965 Ostrach 3(DE)

(72) Erfinder: Biedermann, Andreas
Magenbuch 128
D-7965 Ostrach 3(DE)

(54) Verfahren zur Innenbeschichtung elektrisch nichtleitender Hohlkörper.

(57) Verfahren zur Innenbeschichtung elektrisch nicht leitender Hohlkörper unter Anwendung eines Plasma-CVD-Prozesses, wobei nur der Hohlraum des Körpers unter vermindertem Druck gesetzt wird und die elektrische Leistung für die Plasmaentladung durch die Wand des Hohlkörpers eingekoppelt wird.

EP 0 262 323 A2

Verfahren,die zur Abscheidung von Schichten eine Hochfrequenz-Gasentladung benutzen,sind seit langem bekannt.Dabei kann es sich um reine Sputterprozesse handeln,bei welchen die Schichtsubstanz von einem Target durch die aus der Gasentladung auftreffenden Ionen abgestäubt wird - oftmals wird auch eine Schichtsubstanz gebildet,die aus einem Reaktionsprodukt zwischen Targetsubstanz und Gasbestandteilen besteht.Beispielsweise ist es möglich Titanoxidschichten abzuscheiden,wenn ein metallisches Titantarget verwendet wird und das Sputtergas Sauerstoff enthält.Oder zum Aufbringen von Schichten wird ein sogenanntes CVD-Plasma-Verfahren benutzt ( CVD : chemical vapor deposition ).Dieser Prozeß entnimmt die chemischen Bestandteile der Schicht nur dem Gas,in dem die Entladung brennt.Beispielsweise werden Siliziumnitridschichten abgeschieden,wenn das Gas aus einem Gemisch aus Siliziumtetrafluorid und Ammoniak besteht.Außerdem existiert der Vorschlag,Mischschichten durch gleichzeitige Durchführung von Sputter- und CVD-Plasma-Prozeß zu erzeugen.

Die üblichen Beschichtungsverfahren sind ausgelegt für die Verwendung ebener oder nahezu ebener Substrate,Beispiele sind die Siliziumscheiben der Halbleiterindustrie und Brillengläser in der Optik.In einigen Anwendungsfällen ist es aber notwendig und vorteilhaft,die Innenflächen und nur die Innenflächen von Hohlkörpern - oftmals von Rohren - zu beschichten.

In den DE-OS 28 20 301 und 34 08 053 werden Verfahren zur Innenbeschichtung vermittels Kathodenzerstäubung(Sputterverfahren) vorgeschlagen.Es werden Mittelelektroden als Kathoden verwendet.Die jeweilige Anode wird durch das zu beschichtende (metallische) Rohr selbst gebildet.Deshalb sind diese Verfahren prinzipiell nicht durchführbar,wenn die zu beschichtenden Hohlkörper aus einem elektrisch nicht leitenden Material bestehen.

Die DE-OS 24 45 564 gibt ein weiteres Verfahren zur Innenbeschichtung von Hohlkörpern an.Dabei handelt es sich um ein reines CVD-Verfahren,bei welchem die Schichtsubstanz aus der Reaktion von gas- oder dampfförmigen Verbindungen erhalten wird.Die Anregungsenergie für die Reaktion stammt vollständig aus der Wärmeenergie des geheizten Rohres.Die reinen CVD-Verfahren bedeuten eine hohe thermische Belastung der Substrate.Tatsächlich werden in der erwähnten DE-OS 24 45 564 Abscheidetemperaturen von über 600 Grad Celsius verlangt.

Plasmaangeregte Abscheideverfahren erfordern prinzipiell keine erhöhte Substrat-temperatur.Es erweist sich aber als günstig,wenn die elektrische Feldstärke in der Gasentladung eine nichtverschwindende Normalkomponente auf der Substratoberfläche hat.Dann treffen stark beschleunigte Ionen und Elektronen aus dem Plasma auf die Fläche und beeinflussen den Schichtbildungsprozeß.In der Regel werden dadurch Schichten mit verbesserten Eigenschaften erhalten:zum Beispiel größerer Dichte,größerer Härte,verbesserter Haftfestigkeit.

Bei den bekannten Verfahren zur Innenbeschichtung von elektrisch nicht leitenden Hohlkörpern können die Vorteile einer plasmaangeregten Abscheidung nicht genutzt werden,weil es schwierig ist ,die Elektroden im Vakuumraum so unterzubringen, daß nicht Bereiche der zu beschichtenden Innenfläche abgeschattet werden,eine Normalkomponente der elektrischen Feldstärke vorhanden ist und daß nicht auch die Außenseite des Hohlkörpers beschichtet wird.

Stattdessen werden zur Beschichtung elektrisch nicht leitender Hohlkörper,insbesondere zur Beschichtung von Lampenkolben aus Glas,chemische Tauchverfahren durchgeführt ( DE-OS 34 30 727 ).Diese Verfahren erzeugen im Vergleich zu plasmaangeregten Verfahren allerdings Schichten mit wesentlich schlechteren und stark fluktuierenden Eigenschaften.

Aufgabe der Erfindung ist es,ein Verfahren zur Beschichtung anzugeben,mit dem auch an elektrisch nicht leitenden Hohlkörpern Innenbeschichtungen durchgeführt werden können,wobei das Verfahren die Vorteile plasmaangeregter Abscheidung besitzen soll,insbesondere eine nichtverschwindende Normalkomponente der elektrischen Feldstärke auf der zu beschichtenden Grenzfläche und eine geringe thermische Belastung des Körpers.

Erfindungsgemäß wird die Aufgabe dadurch gelöst,daß ein Plasma-CVD- oder ein Sputterverfahren unter Anwendung eines Hochfrequenzfeldes durchgeführt wird,bei dem die Leistung für die Gasentladung durch die Wand des Hohlkörpers eingekoppelt wird während nur der Hohlraum des Körpers unter verminderten Druck gesetzt ist.Eine Abscheidung auf den Außenflächen ist also unmöglich gemacht.Die Einkopplung kann kapazitiv oder induktiv erfolgen oder beide Arten umfassen,da der Körper aus elektrisch nicht leitendem Material besteht.Weil die Leistung durch die Wand eingekoppelt wird und nur der Hohlraum evakuiert ist,muß sich mindestens eine Elektrode oder Spule außerhalb des Vakuumraumes - in der Regel an Luft - befinden.Damit wird wird die Abschattung der zu beschichtenden Grenzfläche durch die normalerweise notwendige zweite Elektrode im Vakuumraum vermieden.Außerdem bereitet es mit dem erfindungsgemäßen Verfahren keine Schwierigkeiten,die Einkopplung je nach Form des Hohlkörpers so zu gestalten, daß auf den Grenzflächen Normalkomponenten der elektrischen Feldstärke vorhanden sind.

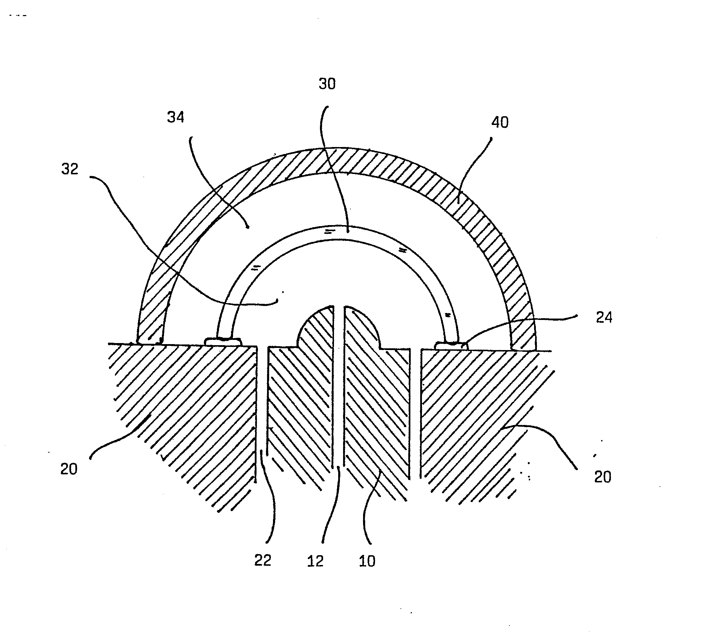

In der Zeichnung ist eine Vorrichtung dargestellt,mit der das erfindungsgemäße Verfahren durchgeführt werden kann.Im Folgenden wird ein Ausführungsbeispiel gegeben:In einer Grundplatte 20 befindet sich - elektrisch isoliert - eine Mittelelektrode 10.Der zu beschichtende Hohlkörper 30,der eine halbkugelförmige Gestalt hat und aus Glas besteht,wird vermittels der Dichtung 24 vakuumdicht auf die Grundplatte aufgesetzt.Die Außenelektrode 40 wird zusammen mit der Grundplatte auf Erdpotential gelegt.An die Mittelelektrode wird eine Hochfrequenzspannung 1000 V / 5 MHz gelegt.

Durch die Kanäle 22 wird der Hohlraum 32 zwischen Halbkugelwand und Mittelelektrode evakuiert.Durch Kanal 12 erfolgt der Gaseinlaß mit einer Strömungsgeschwindigkeit,die den gewünschten Druck ergibt.Der Druck liegt in der Größenordnung 10 Pa.

In dem Ausführungsbeispiel wird die elektrische Leistung durch den Raum 34,in dem normaler Luftdruck herrscht,kapazitiv gekoppelt - im Wesentlichen ohne Verluste.Auch die Wand der Glashalbkugel wird kapazitiv und im Wesentlichen ohne Verluste durchdrungen.Im Raum 32,der unter vermindertem Druck steht,können sich Ionen und Elektronen im elektrischen Feld bewegen.Deshalb wird dort die Leistung freigesetzt.

a) Sputterprozeß

Die Mittelelektrode besteht aus metallischem Titan.Durch den Kanal 12 wird ein Gemisch aus 80% Argon und 20% Sauerstoff eingelassen.Die Gasentladung stäubt von der Mittelelektrode Titan ab,welches mit dem Sauerstoff des Sputtergases reagiert.Auf der Innenfläche der Halbkugel schlägt sich eine Titanoxidschicht nieder.

b) Plasma-CVD-Prozeß

Durch den Kanal 12 wird Sauerstoff mit einem Volumenanteil von 5% Tetraethylorthosilicat eingelassen.Das Plasma der Entladung zersetzt die Siliziumverbindung.Auf dem Glas schlägt sich Siliziumoxid nieder.

# A N S P R Ü C H E

1. Verfahren zur Innenbeschichtung elektrisch nicht leitender Hohlkörper,bei dem in einem unter vermindertem Druck gesetzten Gas eine Hochfrequenz-Gasentladung gezündet wird und durch die Gasentladung eine Beschichtung mit einer Substanz - deren chemische Bestandteile aus dem Gas und/oder von einem Target stammen - hervorgerufen wird,dadurch gekennzeichnet,daß nur der Hohlraum des Körpers unter vermindertem Druck gesetzt wird und daß die elektrische Leistung für die Gasentladung kapazitiv und/oder induktiv durch die Wand des Körpers eingekoppelt wird.

2. Verfahren nach Anspruch 1 ,dadurch gekennzeichnet,daß das Gas eine dampfförmige Titanverbindung enthält.

3. Verfahren nach Anspruch 1 oder 2 ,dadurch gekennzeichnet,daß das Gas eine gas- oder dampfförmige Siliziumverbindung enthält.

4. Verfahren nach Anspruch 2 oder 3 ,dadurch gekennzeichnet,daß das Gas Sauerstoff enthält.